# EUROPEAN PATENT APPLICATION

(11) **EP 4 550 993 A1**
(43) Date of publication of application: **07.05.2025**
(21) Application number: 24205954.1
(22) Date of filing: 10.10.2024
(51) Int. Cl.: H10K 59/80

(54) **DISPLAY APPARATUS**

(30) Priority: 02.11.2023 KR 20230150271
(71) Applicant: Samsung Display Co., Ltd., Gyeonggi-do 17113 (KR)
(72) Inventor: Lee, Jaehun, 17113 Yongin-si, Gyeonggi-do (KR); Kim, Jungi, 17113 Yongin-si, Gyeonggi-do (KR); Ryu, Younjoo, 17113 Yongin-si, Gyeonggi-do (KR); Yun, Sanghyun, 17113 Yongin-si, Gyeonggi-do (KR); Cha, Gwangmin, 17113 Yongin-si, Gyeonggi-do (KR)
(74) Representative: Gulde & Partner

(57) **Abstract**

A display apparatus includes: a substrate comprising a display area and a peripheral area; a display layer in the display area and comprising a pixel circuit and a light-emitting device; an encapsulation layer covering the display layer and in which a first inorganic encapsulation layer, an organic encapsulation layer, and a second inorganic encapsulation layer are stacked; an optical control layer on the encapsulation layer and comprising an organic layer in which a plurality of light blocking lines are arranged; and a middle layer above or below the second inorganic encapsulation layer.

## Description

### BACKGROUND

### 1. Field

Aspects of one or more embodiments relate to a display apparatus.

### 2. Description of the Related Art

Recently, display apparatuses have been used for various purposes. In addition, the display apparatus has become thinner and lighter over time, resulting in a widespread use thereof, and, as the display apparatus is used in various fields, consumer demand for display apparatuses that provide high quality images has increased. Recently, display apparatuses have been arranged inside vehicles to provide videos to users sitting in a driver's seat or a passenger's seat. Light emitted from the display apparatus arranged inside the vehicle is reflected on a window of the vehicle and reaches the user.

The above information disclosed in this Background section is only for enhancement of understanding of the background and therefore the information discussed in this Background section does not necessarily constitute prior art.

### SUMMARY

Light emitted from the display apparatus arranged inside the vehicle may be reflected on a window of the vehicle and reaches the user.

One or more embodiments relate to a display apparatus with improved display quality to ensure that the user's field of view is not obstructed. However, this characteristic is only an example, and the scope of embodiments according to the present disclosure is not limited thereto.

Additional aspects will be set forth in part in the description which follows and, in part, will be apparent from the description, or may be learned by practice of the presented embodiments of the disclosure.

According to some embodiments, a display apparatus includes a substrate including a display area and a peripheral area surrounding the display area, a display layer arranged in the display area and including a pixel circuit and a light-emitting device, an encapsulation layer which covers the display layer and in which a first inorganic encapsulation layer, an organic encapsulation layer, and a second inorganic encapsulation layer are stacked, an optical control layer on the encapsulation layer and including an organic layer in which a plurality of light blocking lines are arranged, and a middle layer above or below the second inorganic encapsulation layer. The middle layer may be an etch-stop layer. The etch-stop layer may include a material having a different etch rate from the etch rate of the organic layer of the optical control layer. The middle layer may be disposed between the encapsulation layer and second inorganic encapsulation layer or between the organic encapsulation layer and the second inorganic encapsulation layer.

According to some embodiments, the display apparatus may further include a wiring portion arranged in the peripheral area and including wirings extending from the display area, wherein the middle layer overlaps the wiring portion.

According to some embodiments, the middle layer may include a transparent conductive material.

According to some embodiments, the organic layer may include a first organic layer and a second organic layer on the first organic layer, and the light blocking line may fill in an opening of the first organic layer and an opening or groove of the second organic layer.

According to some embodiments, a thickness of the second organic layer may be greater than a thickness of the first organic layer.

According to some embodiments, a thickness of the second organic layer may be about 30 µm to about 40 µm.

According to some embodiments, the display apparatus may further include a dam arranged on a same layer as the first organic layer in the peripheral area and apart from the first organic layer.

According to some embodiments, the display apparatus may further include a light blocking member on the dam and including a same material as the plurality of light blocking lines.

According to some embodiments, the organic layer may include a plurality of openings or grooves and the plurality of light blocking lines may respectively fill in the plurality of openings or the grooves.

According to some embodiments, the plurality of light blocking lines may be apart from each other at a regular first interval along one direction.

According to some embodiments, the middle layer may be on the second inorganic encapsulation layer and extend from the display area to the peripheral area.

According to some embodiments, the middle layer may be below the second inorganic encapsulation layer and extend to the peripheral area.

According to some embodiments, the middle layer may be arranged in the peripheral area and may not be arranged in the display area.

According to some embodiments, in the peripheral area, the middle layer may be on the second inorganic encapsulation layer.

According to some embodiments, in the peripheral area, the middle layer may be arranged between the first inorganic encapsulation layer and the second inorganic encapsulation layer.

According to some embodiments, the display apparatus includes a substrate including a display area and a peripheral area, a display layer arranged in the display area and including a pixel circuit and a light-emitting device, a wiring portion arranged in the peripheral area and including wirings extending from the display area, an encapsulation layer which covers the display layer and in which a first inorganic encapsulation layer, an organic encapsulation layer, and a second inorganic encapsulation layer are stacked, an optical control layer on the encapsulation layer and including an organic layer on which the plurality of light blocking lines respectively fill in the plurality of openings or grooves, and a protective layer above or below the second inorganic encapsulation layer and including a transparent conductive oxide.

According to some embodiments, the organic layer may include a first organic layer and a second organic layer on the first organic layer, wherein a thickness of the second organic layer is greater than a thickness of the second organic layer.

According to some embodiments, the display apparatus may further include a dam arranged on a same layer as the first organic layer in the peripheral area and apart from the first organic layer.

According to some embodiments, the plurality of light blocking lines may be apart from each other at a regular first interval along one direction.

According to some embodiments, the protective layer may overlap the wiring portion in the peripheral area.

### BRIEF DESCRIPTION OF THE DRAWINGS

The above and other aspects, features, and characteristics of certain embodiments of the disclosure will be more apparent from the following description taken in conjunction with the accompanying drawings, in which:
FIG. 1 schematically shows an exterior of a vehicle according to some embodiments;
FIG. 2A schematically shows an interior of a vehicle according to some embodiments;
FIG. 2B schematically shows an interior of a vehicle according to some embodiments;
FIG. 3A is a schematic perspective view of a display apparatus according to some embodiments;
FIG. 3B is a schematic plan view of the display apparatus according to some embodiments;
FIG. 4 is an equivalent circuit diagram schematically illustrating a subpixel and a pixel circuit driving the subpixel, according to some embodiments;
FIG. 5 is a plan view illustrating an I area of the display apparatus of FIG. 3B.
FIG. 6 is a schematic cross-sectional view of the display apparatus of FIG. 4 taken along the line II-II';
FIGS. 7A to 7G are schematic cross-sectional views for describing a method of manufacturing a display apparatus, according to some embodiments;
FIG. 8A is a schematic cross-sectional view of a portion of a display apparatus, according to some embodiments;
FIG. 8B is a schematic cross-sectional view of a portion of a display apparatus, according to some embodiments;
FIG. 9 is a schematic cross-sectional view of a portion of a display apparatus, according to some embodiments; and
FIG. 10 is a schematic cross-sectional view of a portion of a display apparatus, according to some embodiments.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Throughout the disclosure, the expression "at least one of a, b, or c" indicates only a, only b, only c, both a and b, both a and c, both b and c, all of a, b, and c, or variations thereof.

Because the disclosure may have diverse modified embodiments, embodiments are illustrated in the drawings and are described in the detailed description. An effect and a characteristic of the disclosure, and a method of accomplishing these will be apparent when referring to embodiments described with reference to the drawings. The disclosure may, however, be embodied in many different forms and should not be construed as limited to the embodiments set forth herein.

Hereinafter, aspects of some embodiments will be described in more detail with reference to the accompanying drawings, wherein the same or corresponding elements are denoted by the same reference numerals throughout and a repeated description thereof is omitted.

In the specification, the terms "first" and "second" are not used in a limited sense and are used to distinguish one component from another component.

As used herein, the singular expressions "a," "an," and "the" are intended to include the plural forms as well, unless the context clearly indicates otherwise.

It will be further understood that the terms "comprises" and/or "comprising" used herein specify the presence of stated features or components, but do not preclude the presence or addition of one or more other features or components.

It will be understood that when a layer, region, or element is referred to as being formed "on" another layer, area, or element, it can be directly or indirectly formed on the other layer, region, or element. That is, for example, intervening layers, regions, or elements may be present.

In the drawings, for convenience of description, sizes of components may be exaggerated or reduced. In other words, because sizes and thicknesses of elements in the drawings are arbitrarily illustrated for convenience of description, the following embodiments are not limited thereto.

When a certain embodiment may be implemented differently, a specific process order may be performed differently from the described order. For example, two consecutively described processes may be performed substantially at the same time or performed in an order opposite to the described order.

In the embodiments hereinafter, it will be understood that when an element, an area, or a layer is referred to as being connected to another element, area, or layer, it can be directly and/or indirectly connected to the other element, area, or layer. For example, it will be understood in this specification that when an element, an area, or a layer is referred to as being in contact with or being electrically connected to another element, area, or layer, it can be directly and/or indirectly in contact with or electrically connected to the other element, area, or layer.

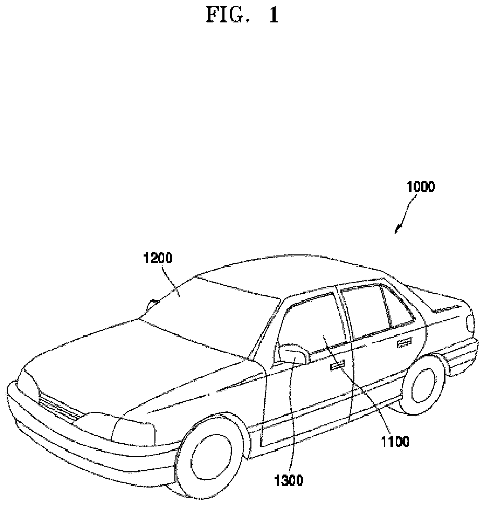

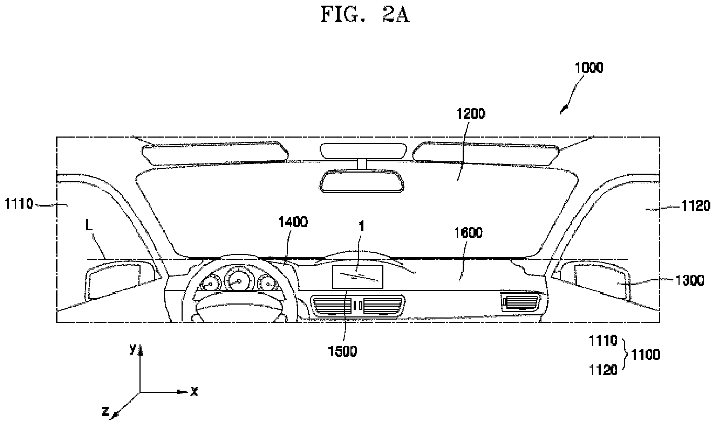

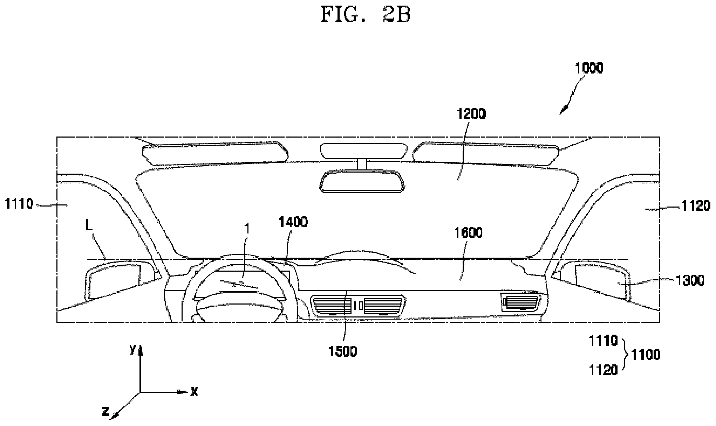

FIG. 1 schematically shows an exterior of a vehicle 1000 according to some embodiments. FIGS. 2A and 2B schematically illustrate an interior of the vehicle 1000 according to some embodiments.

Referring to FIGS. 1, 2A, and 2B, the vehicle 1000 may refer to various apparatuses that move shipments such as humans, objects, or animals from a point of departure to a destination. The vehicle 1000 may include, for example, a vehicle capable of traveling on a road or railway, a vessel capable of navigating on the sea or a river, and/or an aircraft capable of flying through the sky using the action of air.

The vehicle 1000 may travel on a road or railway. The vehicle 1000 may move in a certain direction according to a rotation of at least one wheel. For example, the vehicle 1000 may include a three-wheeled or four-wheeled vehicle, construction machinery, two-wheeled vehicle, driving machine, a bicycle, and a train traveling on the railway.

The vehicle 1000 may include a body including an interior and an exterior and the remaining portion excluding the body, that is, a chassis in which machinery required for driving is installed. The exterior of the body may include a front panel, a bonnet, the roof panel, a rear panel, a trunk, and a filler installed at a boundary between doors. The chassis of the vehicle 1000 may include a power generation apparatus, a power transfer apparatus, a driving apparatus, a steering apparatus, a braking apparatus, a suspension apparatus, a transmission apparatus, a fuel apparatus, and front, rear, left, and right wheels.

The vehicle 1000 may include a side window glass 1100, a front window glass 1200, a side mirror 1300, a cluster 1400, a center fascia 1500, a passenger seat dashboard 1600, and a display apparatus 1.

The side window glass 1100 and the front windows glass 1200 may be divided by a filler located between the side window glass 1100 and the front window glass 1200.

The side window glass 1100 may be installed on a side surface of the vehicle 1000. According to some embodiments, the side window glass 1100 may be installed on a door of the vehicle 1000. A plurality of pieces of side window glass 1100 may be provided and may face each other. According to some embodiments, the side window glass 1100 may include the first side window glass 1110 and the second side window glass 1120. The first side window glass 1110 may be arranged adjacent to the cluster 1400. The second side window glass 1120 may be adjacent to the passenger seat dashboard 1600.

The pieces of side window glass 1100 may be apart from each other in a first direction (e.g., an x direction). For example, the first side window glass 1110 and the second side window glass 1120 may be spaced apart from each other in the x direction. In other words, a virtual connection line L connecting the pieces of side window glass 1100 may extend in the first direction (e.g., the x direction).

The front window glass 1200 may be installed at a front of the vehicle 1000. The front window glass 1200 may be arranged between the pieces of side window glass 1100 facing each other.

The side mirror 1300 may provide a rear view of the vehicle 1000. The side mirror 1300 may be installed on the exterior of the vehicle body. A plurality of side mirrors 1300 may be provided. One of the plurality of side mirrors 1300 may be arranged on the outside of the first side window glass 1110. Another one of the plurality of side mirrors 1300 may be arranged on the outside of the second side window glass 1120.

The cluster 1400 may be arranged in front of the steering wheel. The cluster 1400 may include a tachometer, a speedometer, a coolant temperature gauge, a fuel gauge, a turn signal indicator, a high beam indicator, a warning light, a seatbelt warning light, an odometer, a trip odometer, an automatic gear-shifting selection lever indicator, a door open warning light, an engine oil warning light, and/or a low fuel warning light.

The center fascia 1500 may include an audio apparatus, an air conditioning apparatus, and a control panel on which a plurality of buttons for controlling a heater of a sheet are arranged. The center fascia 1500 may be arranged on one side of the cluster 1400.

The passenger seat dashboard 1600 may be apart from the cluster 1400 with the center fascia 1500 therebetween. According to some embodiments, the cluster 1400 may be arranged to correspond to a driver's seat, and the passenger seat dashboard 1600 may be arranged to correspond to a passenger's seat. According to some embodiments, the cluster 1400 may be adjacent to the first side window glass 1110, and the passenger seat dashboard 1600 may be adjacent to the second side window glass 1120.

The display apparatus 1 may be arranged inside the vehicle 1000. The display apparatus 1 may be arranged between the pieces of side window glass 1100. The display apparatus 1 may display images. According to some embodiments, the display apparatus 1 may be arranged in at least one of the cluster 1400, the center fascia 1500, and the passenger seat dashboard 1600.

The display apparatus 1 may include a liquid crystal display apparatus, an electrophoretic display apparatus, an organic light-emitting display apparatus, an inorganic light-emitting display apparatus, a field emission display apparatus, a surface-conduction electron-emitter display apparatus, a quantum dot display apparatus, a plasma display apparatus, a cathode ray display apparatus, etc. Hereinafter, an organic light-emitting display apparatus is described as an example of the display apparatus 1 according to some embodiments, but various display apparatuses as described above may be used for one or more embodiments.

Referring to FIG. 2A, the display apparatus 1 may be arranged in the center fascia 1500. According to some embodiments, the display apparatus 1 may display navigation information. According to some embodiments, the display apparatus 1 may display information related to an audio, video, or vehicle settings.

Light emitted from the display apparatus 1 may proceed in a certain direction. For example, light emitted from the display apparatus 1 may proceed toward the driver's seat. Light emitted from the display apparatus 1 may proceed toward the passenger's seat. Light emitted from the display apparatus 1 may not proceed toward the front window glass 1200. Alternatively, light emitted from the display apparatus 1 may proceed toward the front window glass 1200 at a relatively low ratio. If light emitted from the display apparatus 1 proceeds toward the front window glass 1200, light emitted from the display apparatus 1 may be reflected by the front window glass 1200 and reach the driver's seat. Thus, the driver may recognize an image of the display apparatus 1 formed in the front window glass 1200 and may not recognize an object in front, and thus, it may not be safe during operation. According to some embodiments, light emitted from the display apparatus 1 arranged in the center fascia 1500 may proceed in a certain direction. Thus, light proceeding toward the front window glass 1200 may be minimized or relatively reduced.

Referring to FIG. 2B, the display apparatus 1 may be arranged in the cluster 1400. In this case, the cluster 1400 may show operation information and the like through the display apparatus 1. That is, the cluster 1400 may be implemented digitally. The digital cluster 1400 may display vehicle information and driving information as an image. For example, the needle and gauge of the tachometer and various warning icons may be displayed by a digital signal.

Light emitted from the display apparatus 1 may proceed in a certain direction. For example, light emitted from the display apparatus 1 may proceed toward the driver's seat. Light emitted from the display apparatus 1 may not proceed toward the front window glass 1200. Alternatively, light emitted from the display apparatus 1 may proceed toward the front window glass 1200 at a relatively low ratio. If light emitted from the display apparatus 1 proceeds toward the front window glass 1200, light emitted from the display apparatus 1 may be reflected by the front window glass 1200 and reach the driver's seat. Thus, the driver may recognize an image of the display apparatus 1 formed in the front window glass 1200, which may cause safety problems during operation. According to some embodiments, light emitted from the display apparatus 1 arranged in the cluster 1400 may proceed in a certain direction. Thus, light proceeding toward the front window glass 1200 may be minimized or relatively reduced.

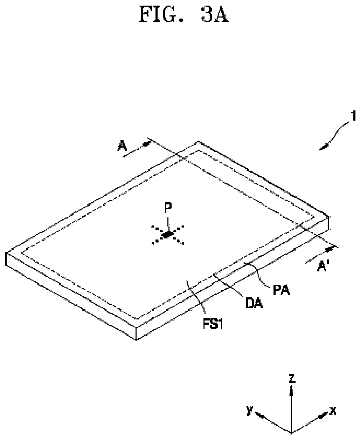

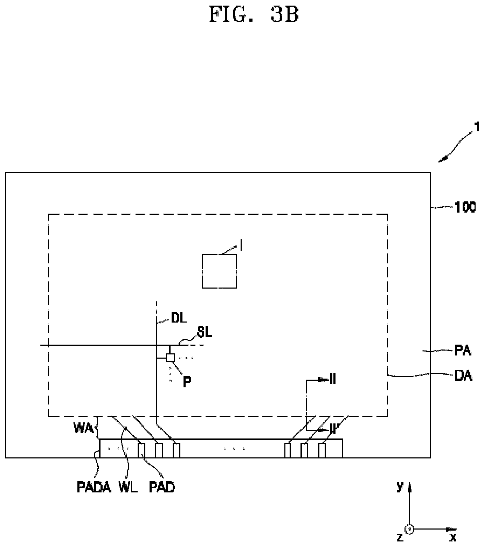

FIG. 3A is a schematic perspective view of the display apparatus 1 according to some embodiments. FIG. 3B is a schematic plan view of the display apparatus 1, according to some embodiments.

Referring to FIGS. 3A and 3B, the display apparatus 1 may include a display area DA and a peripheral area PA. The display apparatus 1 may include a substrate 100 and a multilayer on the substrate 100. The display area DA and the peripheral area PA may be defined in the substrate 100 and/or the multilayer. For example, the substrate 100 may be defined in the display area DA and the peripheral area PA. In other words, the substrate 100 may include the display area DA and the peripheral area PA.

A plurality of subpixels P may be arranged in the display area DA. According to some embodiments, the subpixel P may be arranged in a front surface FS1 of the display apparatus 1.

The plurality of subpixels P may be arranged in the display area DA to display an image. The subpixels P may be implemented as light-emitting devices. Light emitted from the subpixels P may proceed in a certain direction from the front surface FS1 of the display apparatus 1. Light emitted from the subpixels P may proceed in any particular direction from the front surface FS1 of the display apparatus 1. According to some embodiments, light emitted from the subpixel P may proceed in a vertical direction (e.g., a z direction) with respect to the front surface FS1 of the display apparatus 1. According to some embodiments, light emitted from the subpixel P may proceed in an oblique direction (e.g., a direction crossing the z direction) with respect to the front surface FS1 of the display apparatus 1. According to some embodiments, light emitted from the subpixels P may not include a component in at least one of the first direction (e.g., the x direction) and the second direction (e.g., the y direction).

The subpixels P may emit red, green, or blue light by using a light-emitting device. According to some embodiments, the subpixels P may release red, green, blue, or white light using the light-emitting device. The subpixels P may be defined as an emission area of the light-emitting device emitting light in any one of red, green, blue, or white.

The subpixels P may include a light-emitting diode as the light-emitting device configured to emit light of a certain color. The light-emitting diode may include an organic light-emitting diode including an organic material as an emission layer. Alternatively, the light-emitting diode may include an inorganic light-emitting diode. Alternatively, the light-emitting diode may include quantum dots as the emission layer. According to some embodiments, the size of light-emitting diode may be a micro scale or a nano scale. For example, the light-emitting diode may be a micro light-emitting diode. Alternatively, the light-emitting diode may be a nano light-emitting diode. The nano light-emitting diode may include gallium nitrogen (GaN). According to some embodiments, a color conversion layer may be located on the nano light-emitting diode. The color conversion layer may include quantum dots. Hereinafter, for convenience of explanation, a case wherein the light-emitting diode includes an organic light-emitting diode is described.

The pixel circuit configured to drive the subpixels P may be connected to a scan line SL extending in the first direction (e.g., the x direction) and a data line DL extending in the second direction (e.g., the y direction).

The peripheral area PA may not display images. The peripheral area PA may be arranged outside (e.g., in a periphery or outside a footprint of) the display area DA. The peripheral area PA may surround at least a portion of the display area DA. According to some embodiments, the peripheral area PA may surround the entire display area DA. A scan driver configured to provide a scan signal to each subpixel P may be arranged in the peripheral area PA. A data driver configured to provide a data signal to each subpixel P may be arranged in the peripheral area PA. The peripheral area PA may include a pad area PADA. According to some embodiments, pads PAD may be arranged in the pad area PADA. The pad PAD may be exposed without being covered by an insulating layer and be electrically connected to a printed circuit board or a driver IC.

In the peripheral area PA, a wiring portion WA may be arranged between the pad area PADA and the display area DA. The wiring portion WA may include a plurality of wirings WL. The plurality of wirings WL may be configured to transmit signals and/or voltage received from the print circuit board or the driver IC through the pad PAD to a pixel circuit driving the subpixels P arranged in the display area DA.

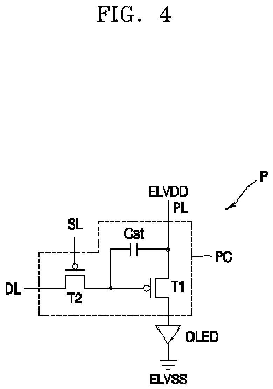

FIG. 4 is an equivalent circuit diagram schematically illustrating the subpixel P and the pixel circuit PC driving the subpixel P, according to some embodiments.

Referring to FIG. 4, the subpixel P may include a pixel circuit PC and an organic light-emitting diode OLED as the light-emitting device. The pixel circuit PC may include a driving transistor T1, a switching transistor T2, and a storage capacitor Cst. Each subpixel P may emit light, such as red, green, or blue light, or emit red, green, blue, or white light, through the organic light-emitting diode OLED.

The switching transistor T2 may be connected to the scan line SL and the data line DL and may transfer a data signal or data voltage input from the data line DL to the driving transistor T1 based on a scan signal or switching voltage input from the scan line SL. The storage capacitor Cst may be connected to the switching transistor T2 and a driving voltage line PL and may store a voltage corresponding to a difference between a voltage received from the switching transistor T2 and a first power voltage ELVDD supplied to the driving voltage line PL.

The driving transistor T1 may be connected to the driving voltage line PL and the storage capacitor Cst and may control a driving current flowing in the organic light-emitting diode OLED through the driving voltage line PL corresponding to a value of the voltage stored in the storage capacitor Cst. The organic light-emitting diode OLED may emit light having a certain brightness according to the driving current. A common electrode (e.g., a cathode) of the organic light-emitting diode OLED may receive a second power voltage ELVSS.

FIG. 4 illustrates the pixel circuit PC including two transistors and one storage capacitor, but in some embodiments, the pixel circuit PC may include three or more transistors. According to various embodiments, the pixel circuit PC may include additional components or circuit elements without departing from the scope of embodiments according to the present disclosure.

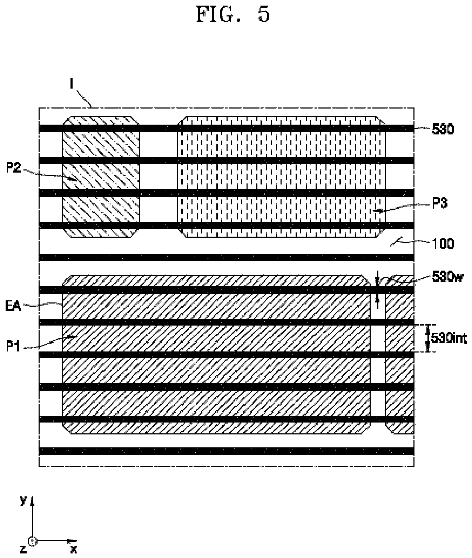

FIG. 5 is a plan view illustrating further details of the area I of the display apparatus of FIG. 3B.

Referring to FIG. 5, a first subpixel P1, a second subpixel P2, and a third subpixel P3 may be located on the substrate 100. Here, the first subpixel P1, the second subpixel P2, and the third subpixel P3 may respectively be defined by the emission areas EA of the light-emitting devices EA of the first subpixel P1, the second subpixel P2, and the third subpixel P3.

The first subpixel P1 may emit light in a first wavelength band. For example, the first subpixel P1 may emit light having a wavelength ranging from about 450 nm to about 495 nm. The second subpixel P2 may emit light in a second wavelength band. For example, the second subpixel P2 may emit light having a wavelength ranging from about 630 nm to about 780 nm. The third subpixel P3 may emit light in a third wavelength band. For example, the third subpixel P3 may emit light having a wavelength ranging from about 495 nm to about 570 nm.

The first subpixel P1, the second subpixel P2, and the third subpixel P3 may have a quadrilateral shape among polygonal shapes. Herein, polygons or quadrilaterals also include shapes having round vertices. The first subpixel P1, the second subpixel P2, and the third subpixel P3 may have a quadrilateral shape having round vertices. According to some embodiments, the first subpixel P1, the second subpixel P2, and the third subpixel P3 may have a circular or elliptical shape.

Sizes of the first subpixel P1, the second subpixel P2, and the third subpixel P3 may be different from each other. For example, an area of the second subpixel P2 may be less than areas of the first subpixel P1 and the third subpixel P3, and the area of the first subpixel P1 may be greater than the area of the third subpixel P3. However, embodiments according to the present disclosure are not limited thereto. The sizes of the first subpixel P1, the second subpixel P2, and the third subpixel P3 may be substantially the same as each other, and various modifications may be made.

A plurality of first subpixels P1 may be provided, and the first sub-pixels P1 may be apart from each other in the first direction (the x direction). A plurality of second subpixels P2 and third subpixels P3 may be repeatedly arranged apart from each other in the first direction (the x direction). A pixel row including the plurality of first pixels P1 arranged in the first direction (the x direction) and a pixel row including the second subpixel P2 and the third subpixel P3 alternately arranged in the first direction (the x direction) may be repeatedly arranged apart from each other in the second direction (the y direction). Embodiments according to the present disclosure are not limited thereto, and the first subpixel P1, the second subpixel P2, and the third subpixel P3 may be arranged in various pixel array structures such as a PenTile^{™} structure, a stripe structure, a mosaic structure or a delta structure.

The display apparatus according to some embodiments may include a plurality of light blocking lines 530 that reflect or absorb light emitted from the first subpixel P1, the second subpixel P2, and the third subpixel P3. As shown in FIG. 5, one subpixel may overlap the plurality of light blocking lines 530. The plurality of light blocking lines 530 may be arranged to extend along the first direction (the x direction).

The plurality of light blocking lines 530 may be apart from each other at a regular interval, that is a first interval 530int. The first interval 530int may be the shortest interval between adjacent light blocking lines. For example, the first interval 530int may be a distance from an edge of the first light blocking line to an edge of the second light blocking line adjacent to the first light blocking line. The first interval 530int may have a range of about 10 µm to about 60 µm. A width 530w of the light blocking line 530 may be about 2 µm to about 10 µm.

The plurality of light blocking lines 530 may limit a certain direction component of light emitted from the first subpixel P1, the second subpixel P2, and the third subpixel P3. For example, when the second direction component of light emitted from the first subpixel P1, the second subpixel P2, and the third subpixel P3 exceeds a certain value to have an exit angle of at least a cut-off angle, the emitted light may be blocked by the light blocking line 530.

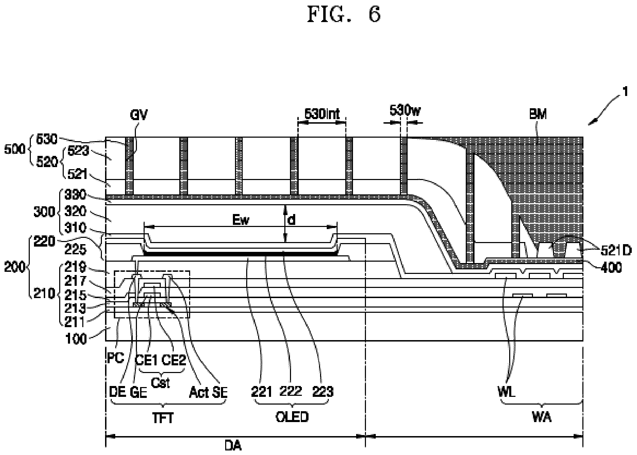

FIG. 6 is a schematic cross-sectional view of the display apparatus 1 of FIG. 4 taken along the line II-II'.

Referring to FIG. 6, the display apparatus 1 may include the substrate 100, a display layer 200, an encapsulation layer 300, an optical control layer 500, and a middle layer 400.

The display layer 200 may be located on the substrate 100. The display layer 200 may include a pixel circuit layer 210 and a light-emitting device layer 220. The pixel circuit layer 210 may include a buffer layer 211, a first gate insulating layer 213, a second gate insulating layer 215, an interlayer insulating layer 217, an organic insulating layer 219 and the pixel circuit PC. The pixel circuit PC may include a thin-film transistor TFT and the storage capacitor Cst. The thin-film transistor TFT may include a semiconductor layer Act, a gate electrode GE, a source electrode SE, and a drain electrode DE.

The buffer layer 211 may be located on the substrate 100. The buffer layer 211 may include inorganic insulating materials such as silicon nitride (SiNₓ), silicon oxynitride (SiON), and silicon oxide (SiO₂) and may have a single-layer or multi-layer structure including the inorganic insulating materials described above.

The semiconductor layer Act may be located on the buffer layer 211. The semiconductor layer Act may include polysilicon. Alternatively, the semiconductor layer Act may include amorphous silicon, an oxide semiconductor, or an organic semiconductor. The semiconductor layer Act may include a channel area and a drain area and a source area respectively arranged in both sides of the channel area.

The first gate insulating layer 213 may be located on the semiconductor layer Act and the buffer layer 211. The second gate insulating layer 215 may include an inorganic insulating material such as SiO₂, SiNₓ, SiON, aluminum oxide (Al₂O₃), titanium oxide (TiO₂), tantalum oxide (TazOs), hafnium oxide (HfO₂), or zinc oxide (ZnOₓ). ZnOₓ may include zinc oxide (ZnO) and/or zinc peroxide (ZnO₂).

The gate electrode GE may be located on the first gate insulating layer 213. The gate electrode GE may overlap the channel area. The gate electrode GE may include a low-resistance metal material. The gate electrode GE may include a conductive material including molybdenum (Mo), aluminum (Al), copper (Cu), titanium (Ti), etc. and may include layers or a single layer including the conductive materials described above.

The second gate insulating layer 215 may be located on the gate electrode GE and the first gate insulating layer 213. Similar to the first gate insulating layer 213, the second gate insulating layer 215 may include an inorganic insulating material such as SiO₂, SiNx, SiON, Al₂O₃, TiO₃, Ta₂O₅, HfO₂, ZnOₓ, or the like.

An upper electrode CE2 of the storage capacitor Cst may be located on the second gate insulating layer 113. The upper electrode CE2 may overlap the gate electrode GE therebelow. In this case, the gate electrode GE and the upper electrode CE2 overlapping each other with the second gate insulating layer 215 therebetween may be included in the storage capacitor Cst. That is, the gate electrode GE may function as a first capacitor plate CE1 of the storage capacitor Cst. According to some embodiments, the storage capacitor Cst may overlap the thin-film transistor TFT. According to some embodiments, the storage capacitor Cst may not overlap the thin-film transistor TFT. The upper electrode CE2 may include aluminum (Al), platinum (Pt), palladium (Pd), silver (Ag), magnesium (Mg), gold (Au), nickel (Ni), neodymium (Nd), iridium (Ir), chromium (Cr), calcium (Ca), molybdenum (Mo), titanium (Ti), tungsten (W), and/or copper (Cu), and may have a single-layer or multi-layer structure including the materials described above.

The interlayer insulating layer 217 may be located on the upper electrode CE2 and the second gate insulating layer 215. The interlayer insulating layer 117 may include SiO₂, SiNₓ, SiON, Al₂O₃, TiO₂, TazOs, HfO₂, ZnOₓ, or the like. The interlayer insulating layer 217 may have a single-layer or multi-layer structure including the above inorganic insulating materials.

The drain electrode DE and the source electrode SE may each be located on the interlayer insulating layer 217. The drain electrode DE and the source electrode SE may each be electrically connected to the semiconductor layer Act. The drain electrode DE and the source electrode SE may include materials with great conductivity. The drain electrode DE and the source electrode SE may include a conductive material including Mo, Al, Cu, Ti, etc. and may include layers or a single layer including the conductive materials described above. According to some embodiments, the drain electrode DE and the source electrode SE may have a multi-layer structure of Ti/Al/Ti.

The organic insulating layer 219 may be located on the drain electrode DE, the source electrode SE, and the interlayer insulating layer 217. The organic insulating layer 219 may include an organic insulating material, such as a general-purpose polymer, such as polymethylmethacrylate (PMMA) or polystyrene (PS), polymer derivatives having a phenol-based group, acryl-based polymers, imide-based polymers, arylether-based polymers, amide-based polymers, fluorine-based polymers, p-xylene-based polymers, vinyl alcohol-based polymers, and a blend thereof. In some embodiments, the organic insulating layer 219 may include a first organic insulating layer and second organic insulating layer.

The light-emitting device layer 220 may be located on the pixel circuit layer 210. The light-emitting device layer 220 may be located on the organic insulating layer 219. The light-emitting device layer 220 may include a light-emitting device implementing a subpixel. The light-emitting device may be an organic light-emitting diode OLED.

The organic light-emitting diode OLED may include a pixel electrode 221, an interlayer 222, and opposite electrode 223. The pixel electrode 221 may be electrically connected to the thin-film transistor TFT through a contact hole of the organic insulating layer 219. The pixel electrode 221 may include a conductive oxide, such as indium tin oxide (ITO), indium zinc oxide (IZO), zinc oxide (ZnO), indium oxide (In₂O₃), indium gallium oxide (IGO), or aluminum zinc oxide (AZO). According to some embodiments, the pixel electrode 221 may include a reflective layer including Ag, Mg, Al, Pt, Pd, Au, Ni, Nd, Ir, Cr, or a compound thereof. In some embodiments, the pixel electrode 221 may further include a layer including ITO, IZO, ZnO or In₂O₃ above/below the reflective layer described above. For example, the pixel electrode 221 may have a multi-layer structure of ITO/Ag/ITO.

A pixel defining layer 225 may cover the edge of the pixel electrode 221. The pixel defining layer 225 may include an opening portion OP. The opening portion OP may expose a central portion of the pixel electrode 221. The opening portion OP may define the emission area of light emitted from the organic light-emitting diode OLED. According to some embodiments, a width Ew of the emission area may be defined as the size of the opening portion OP in the second direction (e.g., the y direction). The width Ew of the emission area may be about 117 µm. According to some embodiments, the pixel defining layer 225 may include an organic material and/or an inorganic material. According to some embodiments, the pixel defining layer 225 may be transparent. According to some embodiments, the pixel defining layer 225 may include a black matrix. In this case, the pixel defining layer 225 may be opaque.

The interlayer 222 may include an emission layer including an organic material. The emission layer may include a high-molecular weight organic material or low-molecular weight organic material, which emits light of certain color. According to some embodiments, a first functional layer and a second functional layer, which are common layers arranged in the display area as a whole, may be located above and/or below the emission layer. The first functional layer may include, for example, a hole transport layer (HTL) and/or a hole injection layer (HIL). The second functional layer may include an electron transport layer (ETL) and/or an electron injection layer (EIL). In some embodiments, the second functional layer may be omitted.

The opposite electrode may be located on the interlayer 222. An opposite electrode 223 may include a conductive material having a low work function. For example, the opposite electrode 223 may include a transparent (or transflective) layer including Ag, Mg, Al, Pt, Pd, Au, Ni, Nd, Ir, Cr, Li, Ca, or an alloy thereof. Alternatively, the opposite electrode 223 may further include a layer, such as ITO, IZO, ZnO, or In₂O₃, on the transparent (or transflective) layer including the material described above.

In some embodiments, a capping layer may be further located on the opposite electrode 223. The capping layer may include LiF, an inorganic material, and/or an organic material.

The wiring portion WA is arranged in the peripheral area PA, and the plurality of wirings WL may be arranged in the wiring portion WA. The wirings WL may transmit electrical signals or voltages to the pixel circuit PC located in the display area DA. According to some embodiments, some of the wirings WL may be provided in the same layer and include the same material as the gate electrode GE of the thin-film transistor TFT. According to some embodiments, some of the wirings WL may be provided in the same layer and include the same material as the source electrode SE and drain electrode DE of the thin-film transistor TFT. According to some embodiments, some of the wirings WL may be provided in the same layer and include the same material as the upper electrode CE2 or lower electrode CE1 of the storage capacitor Cst.

The encapsulation layer 300 may include at least one inorganic encapsulation layer and at least one organic encapsulation layer. FIG. 6 illustrates an encapsulation layer 300 including a first inorganic encapsulation layer 310, an organic encapsulation layer 320, and a second inorganic encapsulation layer 330, which are sequentially stacked.

The first inorganic encapsulation layer 310 and the second inorganic encapsulation layer 330 may include at least one inorganic material among Al₂O₃, TiO₂, TazOs, ZnOₓ, SiO₂, SiNx, and SiON. ZnOₓ may include zinc oxide (ZnO) and/or zinc peroxide (ZnO₂).

The organic encapsulation layer 320 may include a polymer-based material. Examples of the polymer-based material may include an acrylic resin, an epoxy resin, polyimide, and polyethylene. According to some embodiments, at least one organic encapsulation layer 320 may include acrylate.

The encapsulation layer 300 is configured to protect the organic light-emitting diode OLED arranged in the display area DA and only a portion of the encapsulation layer 300 may be arranged in the peripheral area PA. For example, the first inorganic encapsulation layer 310 and the second inorganic encapsulation layer 330 may extend to the wiring portion WA of the peripheral area PA and be in contact with each other in the wiring portion WA. The organic encapsulation layer 320 may extend only to the peripheral area PA between the display area DA and the wiring portion WA.

The optical control layer 500 may be located on the encapsulation layer 300 and include a plurality of light blocking lines 510 arranged in an organic layer 520. The organic layer 520 may include a plurality of openings or grooves GV. The plurality of grooves may be arranged at regular intervals.

The organic layer 520 may include a first organic layer 521 and a second organic layer 523. The first organic layer 521 may include a light-transmissive organic material. In addition, the first organic layer 521 and the second organic layer 523 may include materials with great spreadability on the encapsulation layer 300 to ensure coatability. The first organic layer 521 may include a photosensitive organic material.

In some embodiments, the first organic layer 521 may be an organic material such as epoxy resin, acrylic resin, or imide resin. In some embodiments, the first organic layer 521 may be an ethylene glycol di(meth)acrylate-based polymer, a diethylene glycol di(meth)acrylate-based polymer, a triethylene glycol di(meth)acrylate-based polymer, a 1,6-hexanediol di(meth)acrylate polymer, a pentaerythritol tri(meth)acrylate polymer, a pentaerythritol tetra(meth)acrylate polymer, a dipentaerythritol penta(meth)acrylate polymer, a dipentaerythritol hexa(meth)acrylate polymer, a biphenol A epoxy (meth)acrylate polymer, an ethylene glycol monomethyl ether (meth)acrylate polymer, a trimethylolpropane tri(meth)acrylate polymer, a trisacryloyloxyethylphosphate polymer, and a cardoepoxydiacrylate polymer.

The first organic layer 521 may be arranged in a portion of the display area DA and the peripheral area PA. The first organic layer 521 may be located on the wiring portion WA. A dam 521D may be arranged on the outside of the first organic layer 521. The dam 521D may be apart from the first organic layer 521. The dam 521D may include the same material as the first organic layer 521. The dam 521D may prevent the flow of an organic material included in the second organic layer 523. The dam 521D may overlap the wirings WL of the wiring portion WA on the second inorganic encapsulation layer 330.

The second organic layer 523 may be located on the first organic layer 521 and may be thicker than the first organic layer 521. A thickness t1 of the first organic layer 521 may be several µm or less, for example, about 5 µm or less. A thickness t2 of the second organic layer 523 may be in a range of about 30 µm to about 40 µm.

The second organic layer 523 is an organic material that may be formed by an inkjet and may include an acrylic resin (e.g., polymethylmethacrylate, polyacrylic acid, etc.), ethylhexyl acrylate, pentafluoropropyl acrylate, poly(ethylene glycol) dimethacrylate, ethylene glycol dimethacrylate, or the like. The second organic layer 523 may be arranged in the dam 521D. The first organic layer 521 and the second organic layer 523 may include materials having the same or similar refractive indexes.

The plurality of light blocking lines 530 may respectively fill in the plurality of openings or the grooves GV. The plurality of light blocking lines 530 may be apart from each other at a regular interval, that is a first interval 530int. The first interval 530int may have a range of about 10 µm to about 60 µm. The width 530w of the light blocking line 530 in the second direction (e.g., the y direction) may be about 2 µm to about 10 µm. The plurality of light blocking lines 530 may include a light blocking material. For example, the light blocking material may include black dye, Cr particles, or a metal oxide such as molybdenum oxide. Although light blocking line 530 is arranged vertically with respect to the upper surface of the substrate 100 in the drawing, the disclosure is not limited thereto. A side surface of the light blocking line 530 may be tilted with respect to the upper surface of the substrate 100.

The width Ew of the emission area along the second direction may be an integer multiple of the first interval 530int, which is the interval between the light blocking lines 530. In this case, moire may be reduced or prevented from being generated. Thus, the quality of the display apparatus 1 may be relatively improved.

In addition, according to some embodiments, a vertical distance d between the interlayer 222 and the plurality of light blocking lines 530 may be minimized to minimize the size of double imaging. Thus, the quality of the display apparatus 1 may be improved. As the vertical distance d between the interlayer 222 and the plurality of light blocking lines 530 is increased, the size of double imaging may be increased.

The peripheral area PA may include a light blocking member BM including the same material as the light blocking line 530. The light blocking member BM may be located on the dam 521D. The light blocking member BM may overlap the wirings WL arranged in the wiring portion WA. The light blocking member BM may overlap the wirings WL arranged in the wiring portion WA, and thus, the wirings WL may not be visible from the outside.

When the optical control layer 500 is separately prepared in the form of a film to be attached to the display apparatus 1, the optical control layer 500 may be attached to an upper portion of a different member (e.g., a polarizing film) or may be attached by using an adhesive layer. Accordingly, the distance between the light blocking lines 530 and the interlayer 222 may be increased.

According to some embodiments, because the optical control layer 500 is not prepared as a separate film and is formed after the encapsulation layer 300, the vertical distance d between the interlayer 222 and the plurality of light blocking lines 530 may be significantly reduced, thereby minimizing the width of the dual phase so as not to be visible to the user. The vertical distance d may be about 10 µm to about 50 µm.

The display apparatus 1 according to some embodiments includes the middle layer 400. Hereinafter, the middle layer may be referred to as an etch-stop layer. The etch-stop layer 400 may be a material having a different etch rate from the etch rate of the organic layer 520. The etch-stop layer 400 may include a transparent conductive oxide. For example, the etch-stop layer 400 may include a conductive oxide, such as ITO, IZO, ZnO, indium tin zinc oxide (ITZO), In₂O₃, IGO, or AZO. The etch-stop layer 400 may be a protective layer including a conductive material.

The etch-stop layer 400 may be located on the encapsulation layer 300 or arranged in the encapsulation layer 300. The etch-stop layer 400 may be located on the second inorganic encapsulation layer 330. The etch-stop layer 400 may be arranged between the second inorganic encapsulation layer 330 and the optical control layer 500. As shown in FIG. 6, the etch-stop layer 400 may be arranged in the display area DA. The etch-stop layer 400 may overlap the wirings WL in the wiring portion WA.

Because the etch-stop layer 400 is included, a structure below the etch-stop layer 400 may be prevented from being damaged in the process of etching the organic layer 520. For example, the etch-stop layer 400 may prevent the encapsulation layer 300 or the wiring portion WA from being damaged. Alternatively, when a touch screen layer is located on the encapsulation layer 300, the etch-stop layer 400 may be located on the touch screen layer to prevent damage to the touch screen layer.

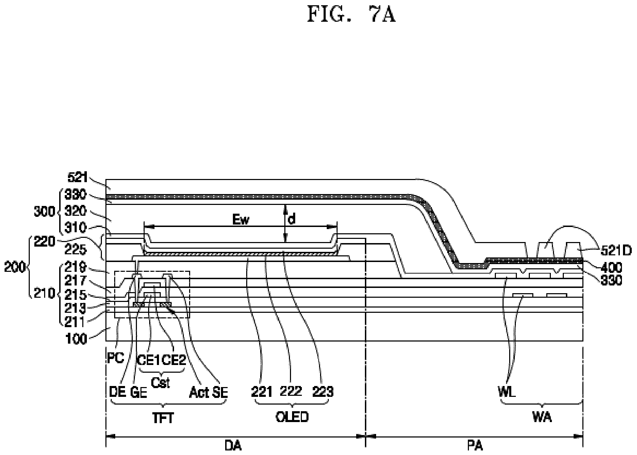

FIGS. 7A to 7G are schematic cross-sectional views for describing a method of manufacturing the display apparatus 1 according to some embodiments.

Referring to FIG. 7A, the display layer 200 is formed in the display area DA of the substrate 100, the wires WL are formed in the peripheral area PA of the substrate 100, and the encapsulation layer 300 covering the display layer 200 and the wires WL are formed.

Then, the first organic layer 521 and the dam 521D are formed on the encapsulation layer 300. A photosensitive organic material having great spreadability is coated and applied, followed by hardening and development, to form the first organic layer 521 and the dams 521D. The first organic layer 521 may be included to obtain coatability of the second organic layer 523 to be formed on the first organic layer 521. The dam 521D is formed apart from the first organic layer 521 and may prevent the second organic layer 523 from flowing to an edge of the substrate 100.

According to some embodiments, the first organic layer 521 may be an organic material such as epoxy resin, acrylic resin, or imide resin. According to some embodiments, the thickness t1 of the first organic layer 521 may be several µm or less, for example, about 5 µm or less.

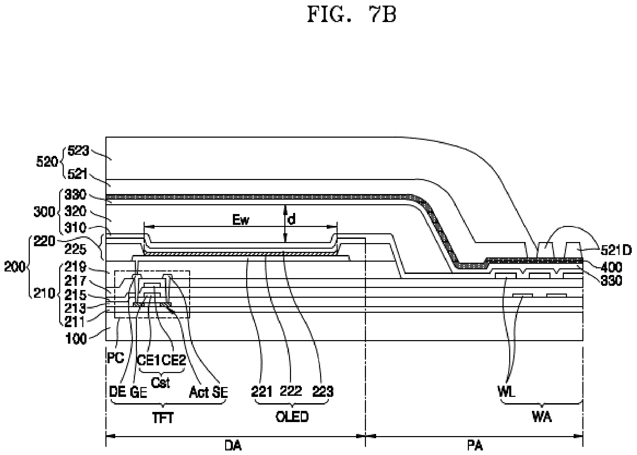

Referring to FIG. 7B, the second organic layer 523 is formed on the first organic layer 521. The second organic layer 523 may be formed by inkjet coating. The second organic layer 523 may be an organic material such as acrylic resin. A thickness t2 of the second organic layer 523 may be about 30 µm to about 40 µm. The second organic layer 523 may extend from the display area DA to reach into the dam 521D of the peripheral area PA.

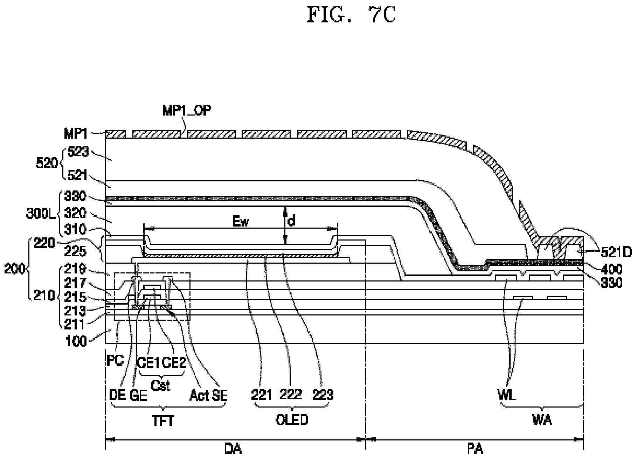

Referring to FIG. 7C, a metal pattern layer MP1 is formed on the second organic layer 523. The metal pattern layer MP1 may include openings MP1_OP at regular intervals. The metal pattern layer MP1 may include a metal such as aluminum.

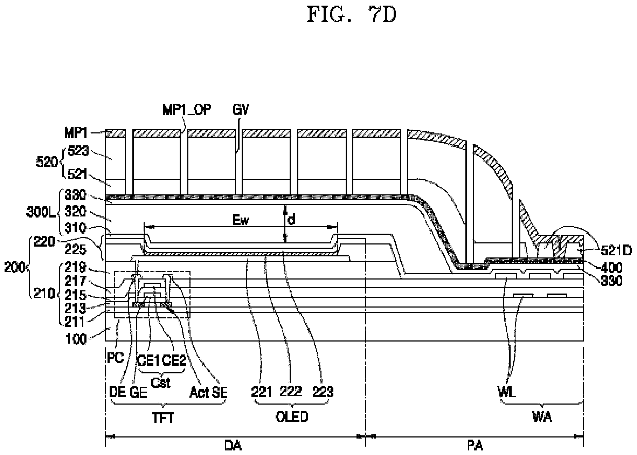

Subsequently, referring to FIG. 7D, the first organic layer 521 and the second organic layer 523 may be etched by using the metal pattern layer MP1 as a mask. The etching may be dry etching. Accordingly, a plurality of openings or grooves GVs corresponding to the openings MP1_OP of the metal pattern layer MP1 may be formed in the first organic layer 521 and the second organic layer 523. The plurality of openings or grooves of the organic layer 520 include the opening of the second organic layer 523 overlapping the opening of the first organic layer 521, but the opening of the second organic layer 523 may overlap the groove of the first organic layer 521. Here, the groove of the first organic layer 521 refers to a portion of the lower surface of the first organic layer 521 that remains without being pierced.

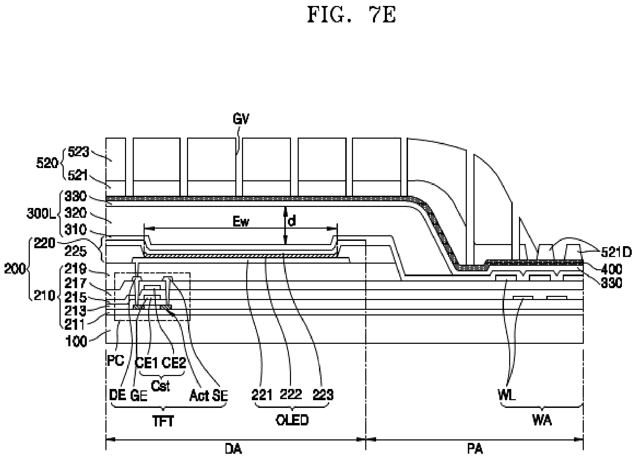

Then, referring to FIG. 7E, the metal pattern layer MP1 removed by etching. The metal pattern layer MP1 can be removed by dry etching. The condition for etching the metal pattern layer MP1 may be different from the condition for etching the first organic layer 521 and the second organic layer 523.

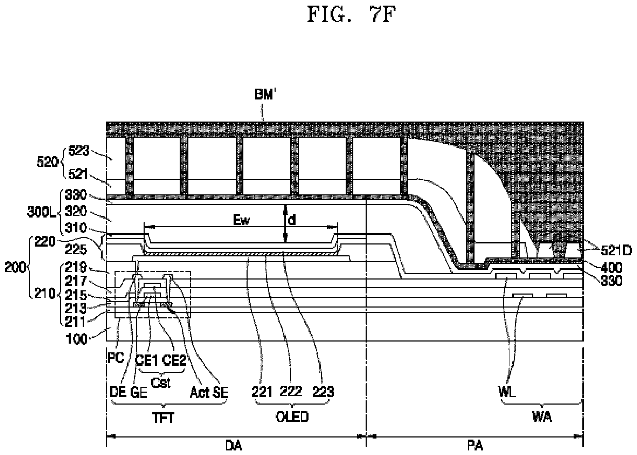

Subsequently, referring to FIG. 7F, an organic material BM' including a light blocking material is applied on the organic layer 520 to fill in the openings and the grooves GV of the organic layer 520 arranged in the display area DA and to overlap the wiring portion WA of the peripheral area PA. The light blocking material may include black dye, Cr particles, or a metal oxide such as molybdenum oxide. The organic material BM' may be hardened after being applied.

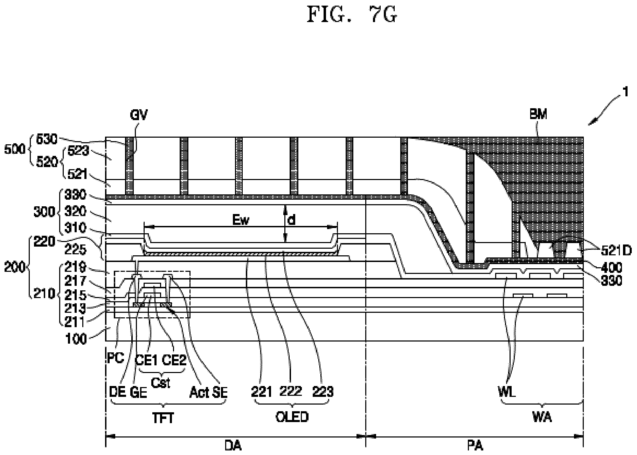

Subsequently, referring to FIG. 7G, the upper surface of the organic layer 520 is exposed through chemical mechanical polishing of the organic material BM' including the light blocking material. Accordingly, the plurality of light blocking lines 530 corresponding to the display area DA and the light blocking member BM corresponding to the peripheral area PA may be formed.

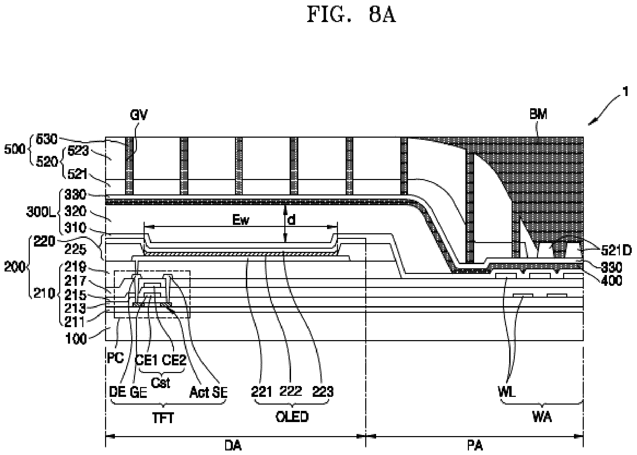

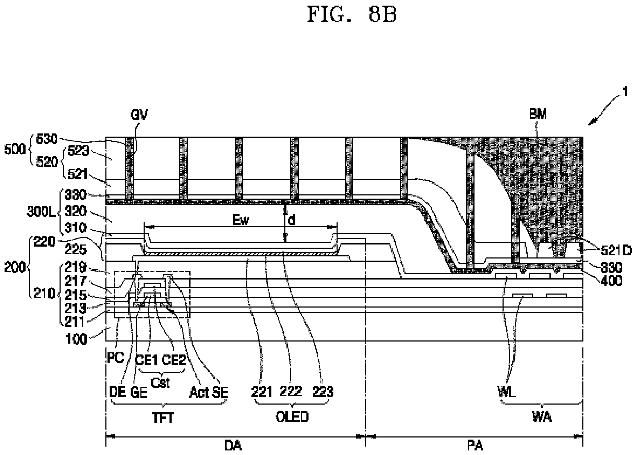

FIGS. 8A and 8B are schematic cross-sectional views of a portion of the display apparatus 1 according to some embodiments. In FIGS. 8A and 8B, the same references numerals as those in FIG. 6 denote the same members.

Referring to FIGS. 8A and 8B, the display apparatus 1 may include the substrate 100 including the display area DA and the peripheral area PA, the display layer 200 arranged in the display area DA and including the pixel circuit PC and the light-emitting device, the encapsulation layer 300 covering the display layer 200 and on which the first inorganic encapsulation layer 310, the organic encapsulation layer 320, and the second inorganic encapsulation layer 330 are stacked, the optical control layer 500 located on the encapsulation layer 300 and including the organic layer 520 in which the plurality of light blocking line 530 are arranged, and the etch-stop layer 400 located above or below the second inorganic encapsulation layer 330. The plurality of light blocking lines 530 may fill in the openings or the grooves GV included in the organic layer 520.

According to some embodiments, the etch-stop layer 400 may be arranged in the encapsulation layer 300. For example, the etch-stop layer 400 may be located under the second inorganic encapsulation layer 330. In the display area DA, the etch-stop layer 400 may be arranged between the organic encapsulation layer 320 and the second inorganic encapsulation layer 330. In the peripheral area PA, the etch-stop layer 400 may be arranged between the first inorganic encapsulation layer 310 and the second inorganic encapsulation layer 330. The etch-stop layer 400 may extend from the display area DA to the peripheral area PA. The etch-stop layer 400 may include a transparent conductive oxide.

Because the etch-stop layer 400 is arranged in or located on the encapsulation layer 300 in the display area DA, the components below the etch-stop layer 400 may be protected during the etching process of the organic layer 520. Because the etch-stop layer 400 overlaps the wiring portion WA arranged in the peripheral area PA, the wirings WL may be prevented from being damaged during the etching process of the organic layer 520.

Because the etch-stop layer 400 is located under the second inorganic encapsulation layer 330, as shown in FIG. 8B, the second inorganic encapsulation layer 330 located on the etch-stop layer 400 may be partially removed when forming the openings or the grooves GV of the organic layer 520. According to some embodiments, the second inorganic encapsulation layer 330 may include an opening or groove corresponding to the light blocking line 530, and a portion of the light blocking line 530 may be arranged in the opening or the groove.

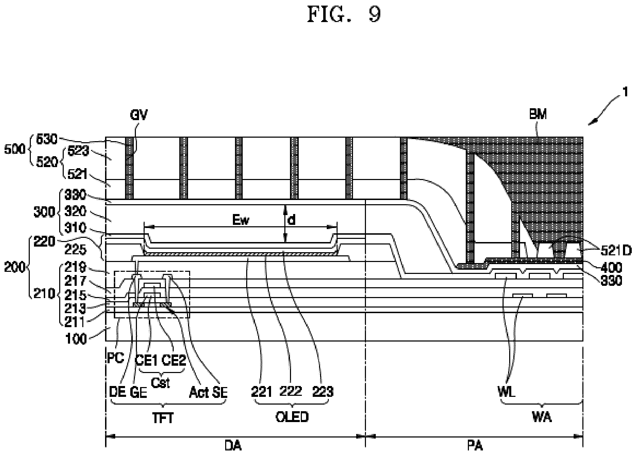

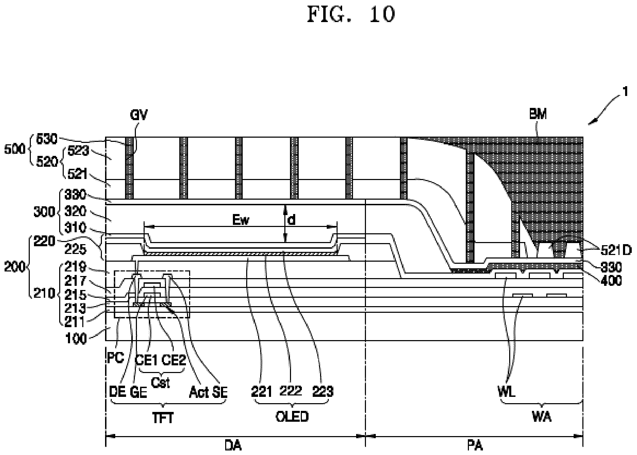

FIGS. 9 and 10 are schematic cross-sectional views of a portion of the display apparatus 1 according to some embodiments. In FIGS. 9 and 10, the same references numerals as those in FIG. 6 denote the same members.

Referring to FIGS. 9 and 10, the display apparatus 1 may include the substrate 100 including the display area DA and the peripheral area PA, the display layer 200 arranged in the display area DA and including the pixel circuit PC and the light-emitting device, the encapsulation layer 300 covering the display layer 200 and on which the first inorganic encapsulation layer 310, the organic encapsulation layer 320, and the second inorganic encapsulation layer 330 are stacked, the optical control layer 500 located on the encapsulation layer 300 and including the organic layer 520 in which the plurality of light blocking line 530 are arranged, and the etch-stop layer 400 located above or below the second inorganic encapsulation layer 330.

In the present embodiments, the etch-stop layer 400 may not be arranged in the display area DA and overlap the wiring portion WA of the peripheral area PA.

As shown in FIG. 9, the etch-stop layer 400 may be located on the second inorganic encapsulation layer 330 in the peripheral area PA. In some embodiments, as illustrated in FIG. 10, the etch-stop layer 400 may be arranged between the first inorganic encapsulation layer 310 and the second inorganic encapsulation layer 330 in the peripheral area PA.

Because the etch-stop layer 400 overlaps the wiring portion WA arranged in the peripheral area PA, the wirings WL may be prevented from being damaged during the etching process of the organic layer 520.

As shown in FIG. 10, when the etch-stop layer 400 is located under the second inorganic encapsulation layer 330, the second inorganic encapsulation layer 330 may include an opening or a groove corresponding to the light blocking line 530, and a portion of the light blocking line 530 may be arranged in the opening or the groove.

As described above, in the one or more embodiments, because the optical control layer including the plurality of light blocking lines is provided rather than the polarization layer, the quality of the display apparatus may be relatively improved.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope of embodiments according to the present disclosure as defined by the following claims, and their equivalents.

## Claims

1. A display apparatus (1) comprising:
a substrate (100) comprising a display area and a peripheral area;
a display layer (200) in the display area and comprising a pixel circuit and a light-emitting device;
an encapsulation layer (300) covering the display layer (200) and in which a first inorganic encapsulation layer (310), an organic encapsulation layer (320), and a second inorganic encapsulation layer (330) are stacked;
an optical control layer (500) on the encapsulation layer (300) and comprising an organic layer (520) in which a plurality of light blocking lines (510, 530) are arranged; and
a middle layer (400) above or below the second inorganic encapsulation layer (330).

2. The display apparatus (1) of claim 1, further comprising a wiring portion in the peripheral area and comprising wirings extending from the display area, wherein the middle layer (400) overlaps the wiring portion.

3. The display apparatus (1) of claim 1 or 2, wherein the middle layer (400) comprises a transparent conductive material.

4. The display apparatus (1) of any of the preceding claims, wherein the organic layer (520) comprises a first organic layer (521) and a second organic layer (523) on the first organic layer (521), and the light blocking line (510, 530) fills in an opening of the first organic layer (521) and an opening or groove of the second organic layer (523).

5. The display apparatus (1) of claim 4, wherein a thickness of the second organic layer (523) is greater than a thickness of the first organic layer (521).

6. The display apparatus (1) of claim 4 or 5, wherein a thickness of the second organic layer (523) is in a range of 30 micrometers (µm) to 40 µm.

7. The display apparatus (1) of any of claims 4 to 6, further comprising a dam (521D) on a same layer (400) as the first organic layer (521) in the peripheral area and spaced apart from the first organic layer (521).

8. The display apparatus (1) of claim 7, further comprising a light blocking member on the dam (521D) and comprising a same material as the plurality of light blocking lines (510, 530).

9. The display apparatus (1) of any of the preceding claims, wherein the organic layer (520) comprises a plurality of openings or grooves, and the plurality of light blocking lines (510, 530) respectively fill in the plurality of openings or the grooves.

10. The display apparatus (1) of any of the preceding claims, wherein the plurality of light blocking lines (510, 530) are spaced apart from each other at a regular first interval (530int) along one direction.

11. The display apparatus (1) of any of the preceding claims, wherein the middle layer (400) is on the second inorganic encapsulation layer (330) and extends from the display area to the peripheral area.

12. The display apparatus (1) of any of claims 1 to 10, wherein the middle layer (400) is below the second inorganic encapsulation layer (330) and extends to the peripheral area.

13. The display apparatus (1) of any of claims 1 to 10, wherein the middle layer (400) is arranged in the peripheral area and is not arranged in the display area.

14. The display apparatus (1) of claim 13, wherein, in the peripheral area, the middle layer (400) is on the second inorganic encapsulation layer (330).

15. The display apparatus (1) of claim 13 or 14, wherein, in the peripheral area, the middle layer (400) is between the first inorganic encapsulation layer (310) and the second inorganic encapsulation layer (330).
